# EUROPEAN PATENT APPLICATION

(11) **EP 4 716 098 A1**
(43) Date of publication of application: **25.03.2026**
(21) Application number: 25204103.3
(22) Date of filing: 23.09.2025
(51) Int. Cl.: H03F 1/22, H03F 3/193, H03F 3/217, H03F 3/24

(54) **SELF-BIASED LOW HARMONICS HIGH-EFFICIENCY INVERSE CLASS-D RF POWER AMPLIFIER CIRCUITRY**

(30) Priority: 24.09.2024 US 202463698193 P; 18.07.2025 US 202519273584
(71) Applicant: QORVO US, INC., Greensboro, NC 27409 (US)
(72) Inventor: ATES, Erdogan Ozgur, Greensboro, 27409 (US)
(74) Representative: D Young & Co LLP

(57) **Abstract**

Power amplifier circuitry is disclosed having an inverse Class-D amplifier functioning as a power amplifier and self-biasing circuitry generating gate bias voltages for switching type power transistors within the power amplifier. The self-biasing circuitry includes a low-dropout regulator that generates and applies a gate bias voltage in response to a feedback current scaled according to the power amplifier's operating current. A current-based digital-to-analog converter is configured to generate the reference current based on a received digital value. Additionally, a digital processor is configured to generate the digital value in response to the gate bias voltage. The power amplifier circuitry enhances performance and efficiency while ensuring precise control over power transistors' operation, offering advantages for various applications requiring radio frequency signal amplification.

## Description

### Related Applications

This application claims the benefit of provisional patent application serial number 63/698,193, filed September 24, 2024, the disclosure of which is hereby incorporated herein by reference in its entirety.

### Field

The present disclosure is directed to high-efficiency power amplifiers for low-power, low-cost radios such as unlicensed radios including ultra-wide band radios. The disclosure provides an inverse class-D radio frequency power amplifier with self-biasing that results in improved output power spectrum in response to changes in antenna impedance.

### Background

High-efficiency power amplifiers with low harmonics conduction are a challenge for the low-power, low-cost radios such as Zigbee, Bluetooth^{®} Low Energy, and ultra wideband. Research has been focused on improving the trade-offs between efficiency and linearity. Class-D switching power amplifiers offer greater efficiency compared with Class-A/B/AB radio frequency power amplifiers; however, Class-D switching power amplifiers suffer from increased third harmonic components. The present disclosure relates to a lower second-order harmonic/third-order harmonic inverse class-D radio frequency power amplifier that is demonstrated to have improved efficiency and very low harmonics generated. Self-biasing the power amplifier using a current-based digital-to-analog converter results in better output power spread and power change with antenna impedance.

### Summary

Particular aspects are set out in the appended independent claims. Various optional embodiments are set out in the dependent claims.

Power amplifier circuitry is disclosed having an inverse Class-D amplifier functioning as a power amplifier and self-biasing circuitry generating gate bias voltages for switching type power transistors within the power amplifier. The self-biasing circuitry includes a low-dropout regulator that generates and applies a gate bias voltage in response to a feedback current scaled according to the power amplifier's operating current. A current-based digital-to-analog converter is configured to generate a reference current based on a received digital value. Additionally, a digital processor is configured to generate the digital value fed to the digital-to-analog converter. The power amplifier circuitry enhances performance and efficiency while ensuring precise control over power transistors' operation, offering advantages for various applications requiring radio frequency signal amplification.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure and, together with the description, serve to explain the principles of the disclosure.
FIG. 1 is a diagram showing an example embodiment of power amplifier circuitry designed to amplify radio frequency (RF) signals using an inverse Class-D configuration.
FIG. 2 is a diagram showing a current digital-to-analog converter circuit.
FIG. 3 is a diagram showing a 50% duty-cycle square waveform.
FIG. 4 is a diagram showing a spectrum of the 50% duty-cycle square waveform.
FIG. 5 is a diagram showing a 33.33% duty-cycle square waveform.
FIG. 6 is a diagram showing a spectrum of the 33.33% duty-cycle square waveform.
FIG. 7 is a plot showing output power vs. different real antenna impedances.
FIG. 8 is a graph of power amplifier load current versus load reflection coefficient phase angle for various load reflection coefficient magnitudes.
FIG. 9 is a diagram showing how the inverse Class-D radio frequency power amplifier may be employed in communication devices such as wireless communication devices.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

The present disclosure addresses the challenge of achieving high efficiency in power amplifiers with low harmonic distortion, particularly for low-power, low-cost radios such as Zigbee, Bluetooth^{®} Low Energy, and ultra wideband. Class-D switching power amplifiers offer greater efficiency compared with Class-A/B/AB radio frequency (RF) power amplifiers but suffer from increased third harmonic components. The embodiments disclosed herein demonstrate a lower H2/H3 inverse class-D RF power amplifier that results in improved efficiency and very low harmonics generated. Embodiments of the present disclosure each employ a feedback loop that controls the output power of an antenna load by comparing the current drawn from the load with a reference current. The comparison is used to adjust the output power to maintain a constant level of output power despite changes in load impedance.

Several benefits to using the embodiments according to the present disclosure may include the following:
- Self-biased architecture using a current-based digital-to-analog converter simplifies the output power programming and its spread over process, voltage, and temperature.
- Very low second-order and third-order harmonics are generated with a demonstrated solution which results in a reduction of RF off-chip filter components and reduced cost.
- A high-efficiency power amplifier results in a lower current consumption, decreasing overall system cost and improving battery lifetime substantially.

Certain embodiments according to the present disclosure may include the following:
- A self-biasing loop to have power amplifier current stabilization for a desired power output level.
- A fully integrated transformer balanced/unbalanced and differential inverse class D RF power amplifier to reduce a second-order harmonic (H2) generated.
- Input a 33% duty-cycled RF signal to reduce a third-order harmonic (H3) component and improve the power amplifier drain efficiency.

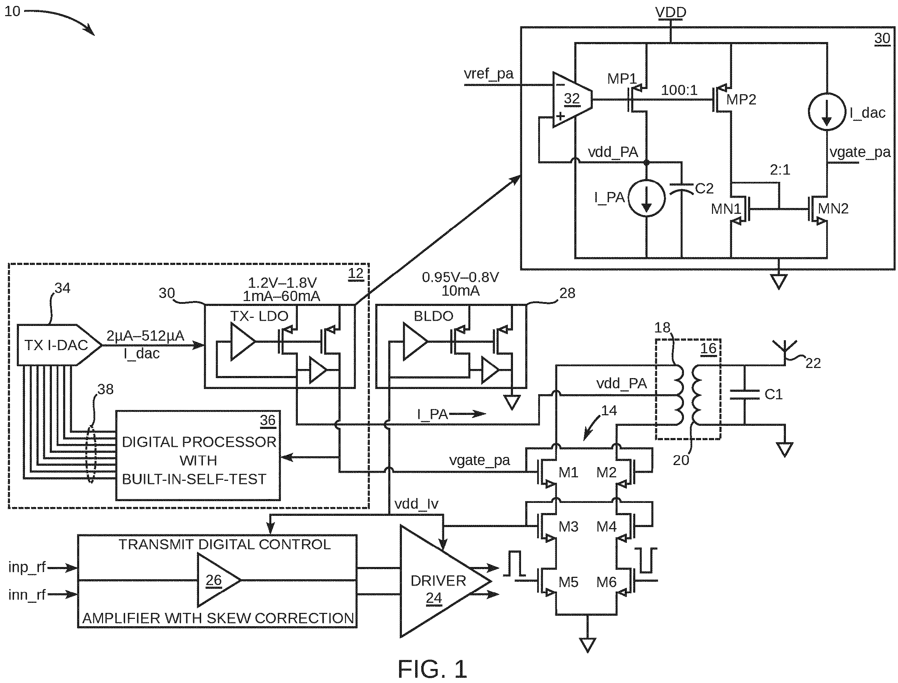

An example embodiment of power amplifier circuitry 10 depicted in FIG. 1 is designed to amplify radio frequency (RF) signals using an inverse Class-D configuration. A self-biasing circuitry 12 is configured to generate the gate bias voltage of a first transistor M1 and a second transistor M2 that make up a power amplifier 14 that is configured in the inverse Class-D configuration. The first transistor M1 and the second transistor M2 are switching type power transistors. In the example embodiment of FIG. 1, the first transistor M1 and the second transistor M2 are of the laterally diffused metal-oxide semiconductor (LDMOS) type. A third transistor M3 is coupled in cascode with the first transistor M1, and a fourth transistor M4 is coupled in cascode with the second transistor M2. The first transistor M1 and the second transistor M2 isolate inputs of the power amplifier 14 from high output voltage swings at drains of the first transistor M1 and second transistor M2, allowing the third transistor M3 and the fourth transistor M4 to switch more efficiently without suffering from breakdown due to high voltage stress. A fifth transistor M5 is coupled between a source of the third transistor M3 and ground. A sixth transistor M6 is coupled between a source of the fourth transistor M4 and ground. The fifth transistor M5 and the sixth transistor M6 operate at relatively high speeds and help shape the current waveform flowing through the amplifier 14. In inverse Class D operation, the fifth transistor M5 and the sixth transistor M6 ensure that the current waveform remains close to square wave, for efficient RF power transfer. By using a 33.33% duty-cycle input signal, drain efficiency and H3 levels are improved substantially. There is no penalty for the H2 level since the design is fully differential. This improves power amplifier efficiency as there is less power dissipated on the power amplifier transistors when the metal oxide semiconductor transistors are conducting.

An RF transformer 16 has a tapped input winding 18 that is coupled to the drains of the first transistor M1 and the second transistor M2. The RF transformer 16 also has an output winding 20 coupled between an antenna 22 and ground. A first capacitor C1 is coupled across the output winding 20 and is configured to tune, filter, and ensure proper impedance matching at the desired frequency, enhancing the performance and efficiency of the power amplifier 14.

The power amplifier 14 is driven by a driver 24 that receives skew corrected RF signals from a transmit digital control amplifier 26 that is configured to provide skew correction to RF signals (inp_rf, inn_rf). The transmit digital control amplifier 26 is employed to address timing mismatches, or "skew," between signals. In this disclosure, skew refers to the time difference between events that ideally should occur simultaneously. By correcting these timing mismatches, the skew correction provided by the transmit digital control amplifier 26 ensures that the signals are properly aligned before they reach the power amplifier driver. This helps maintain the quality and reliability of the amplified RF signal, reducing errors and improving the overall performance of the system.

A block low-dropout (BLDO) regulator 28 supplies a regulated voltage vdd_lv to the transmit digital control amplifier 26, the driver 24, and a gate bias voltage for the third transistor M3 and the fourth transistor M4. In the example embodiment of FIG. 1, the BLDO regulator 28 maintains the regulated voltage vdd_Iv between 0.95V and 0.8V at 10 milliamperes.

A transmitter low-dropout (TX-LDO) regulator 30 making up the self-biasing circuitry 12 generates a controlled gate bias voltage vgate_pa for the first transistor M1 and the second transistor M2. The TX-LDO regulator 30 also generates a power amplifier current I_PA and a supply voltage vdd_PA that powers the power amplifier 14. In the example embodiment of FIG. 1, the power amplifier current I_PA is adjustable between 1mA and 60mA, and the supply voltage vdd_PA is adjustable between 1.2V and 1.8V.

Referring now to a more detailed schematic of the TX-LDO regulator 30 in an outset diagram of FIG. 1, the power amplifier 14 behaves as a current source for the power amplifier current I_PA during the switching operation of the first transistor M1 and the second transistor M2, which in this example embodiment are thick oxide transconductance transistors. The power amplifier current I_PA flows through a relatively large first p-type metal-oxide semiconductor (PMOS) transistor MP1 mirrored by a second PMOS transistor MP2 and a first n-type (NMOS) transistor MN1 and a second NMOS transistor MN2 with a combined 1:200 ratio. A resulting current is compared with a current-based digital-to-analog converter (I-dac) current, and a feedback voltage that sets the gate bias voltage vgate_pa of the first transistor M1. The supply voltage vdd_PA is filtered by a second capacitor C2 and is fed into a noninverting terminal of a voltage comparator 32 that compares the supply voltage vdd_PA with an external reference voltage vref_pa and in response dynamically biases gates of the first PMOS transistor MP1 and the second PMOS transistor MP2.

The I-dac current is generated by a transmit (TX) I-DAC 34. In the example embodiment of FIG. 1, the TX IDAC 34 is configured to adjust the I-dac current between 2µA and 512µA. The TX I-DAC 34 is controlled by a digital processor 36 over a digital bus 38. The digital processor 36 is configured to receive feedback of the gate bias voltage vgate_pa and in response generate and send a digital value over the digital bus to the TX I-DAC 34. The digital processor 36 may generate the digital value under the control of firmware and/or a look-up table. The mirroring of the I-dac current and the digital processor 36 provides a self-bias programmatic adjustment of the power amplifier current I_PA and hence output power delivered by the power amplifier 14.

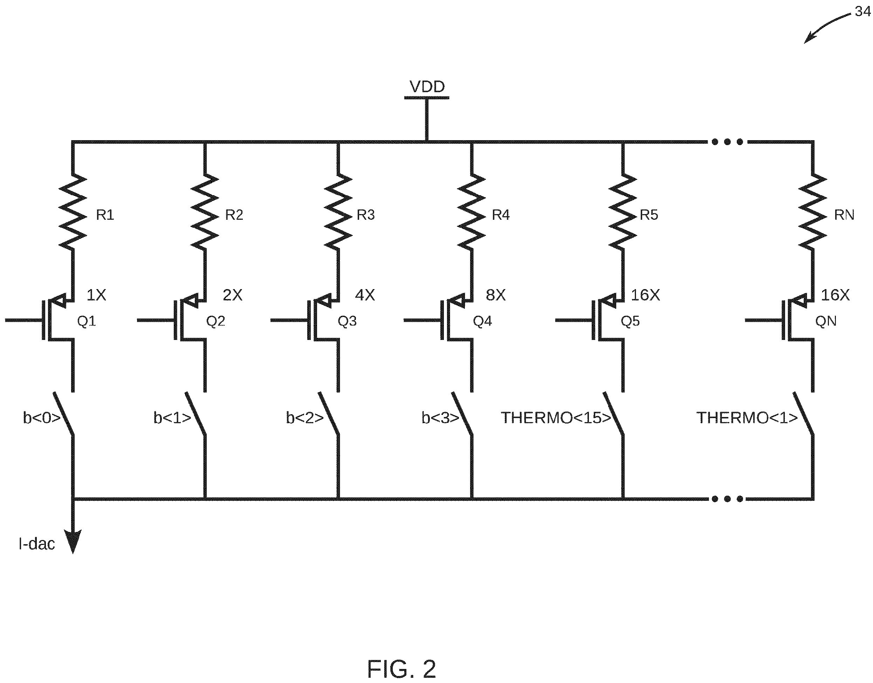

An example embodiment of the TX I-DAC 34 is shown in FIG. 2. The TX I-DAC 34 in this example embodiment provides 4-bit binary scaled PMOS current sources. The 4 most significant bits are implemented as thermometer coded 16x scaled PMOS current sources. The TX-DAC 34 has parallel branches made up of series coupled resistors R1-RN, current sources Q1-QN, and bit switches b<0> through THERMO<15>.

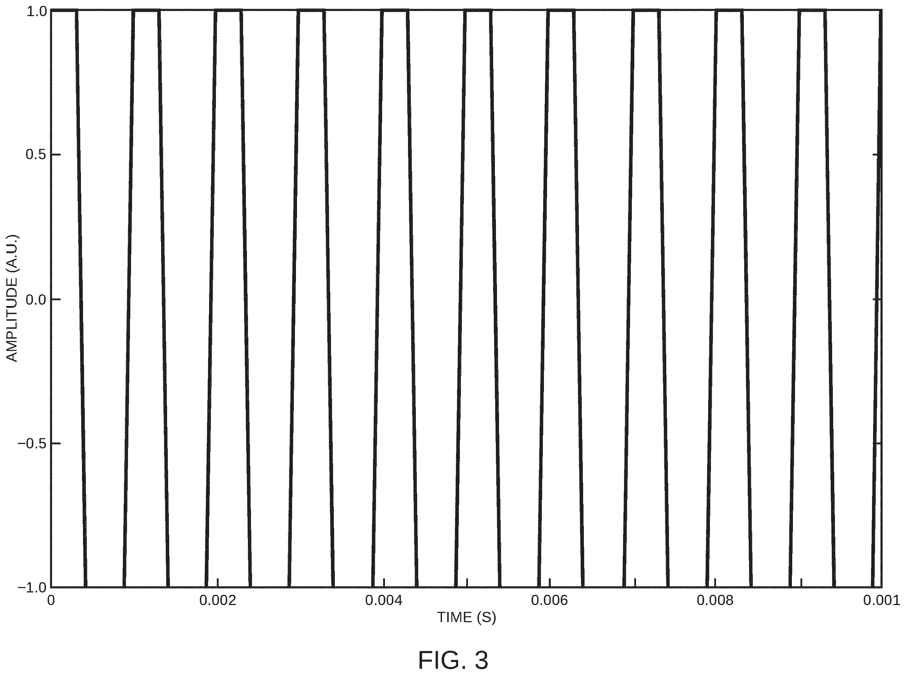

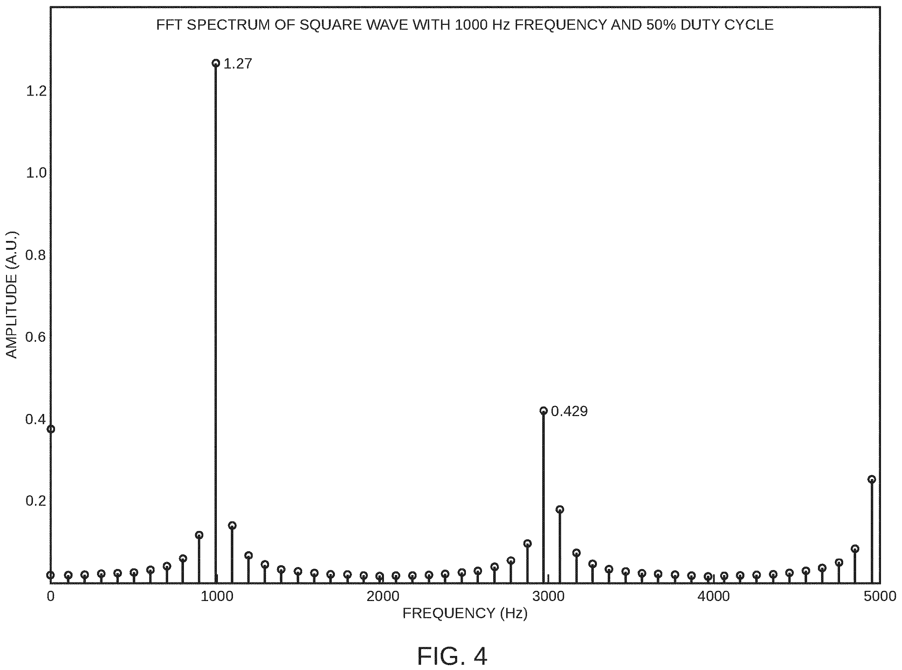

FIG. 3 shows a 50% duty-cycle square waveform that is used with traditional inverse class-D RF power amplifiers. Associated 50% duty-cycle signal Fast Fourier Transform results are shown in FIG. 4.

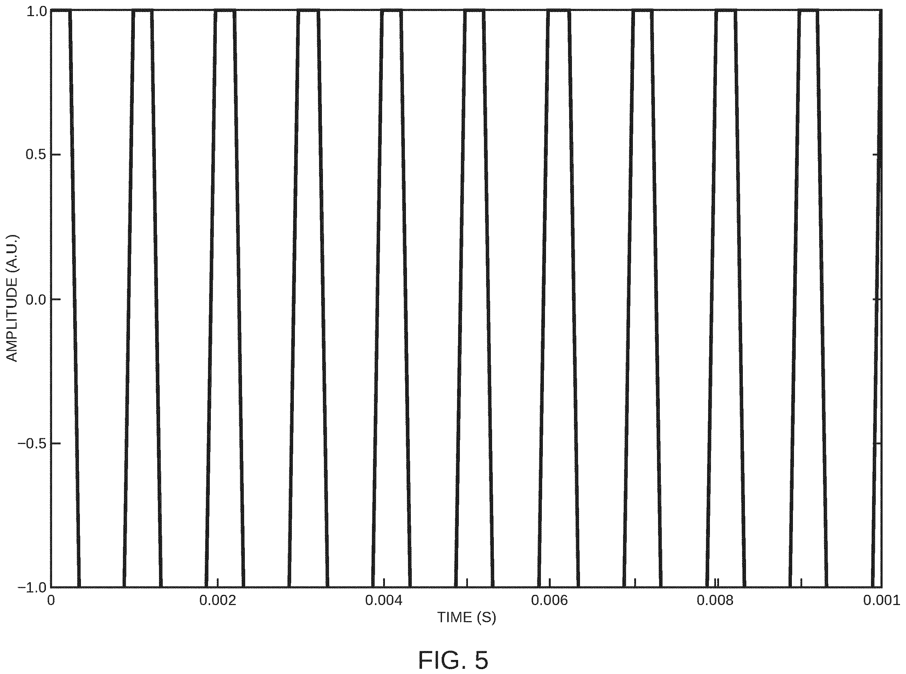

FIG. 5 shows a 33.33% duty-cycle square waveform employed by embodiments of the present disclosure. By using a 33.33% duty-cycle input signal, drain efficiency and third-order harmonic (H3) levels are improved substantially over the H3 levels generated by the 50% duty-cycle square waveform depicted in FIG. 3 and compared with the H3 levels depicted in FIG. 4. There is no penalty for the second-order harmonic (H2) level, since the design is fully differential.

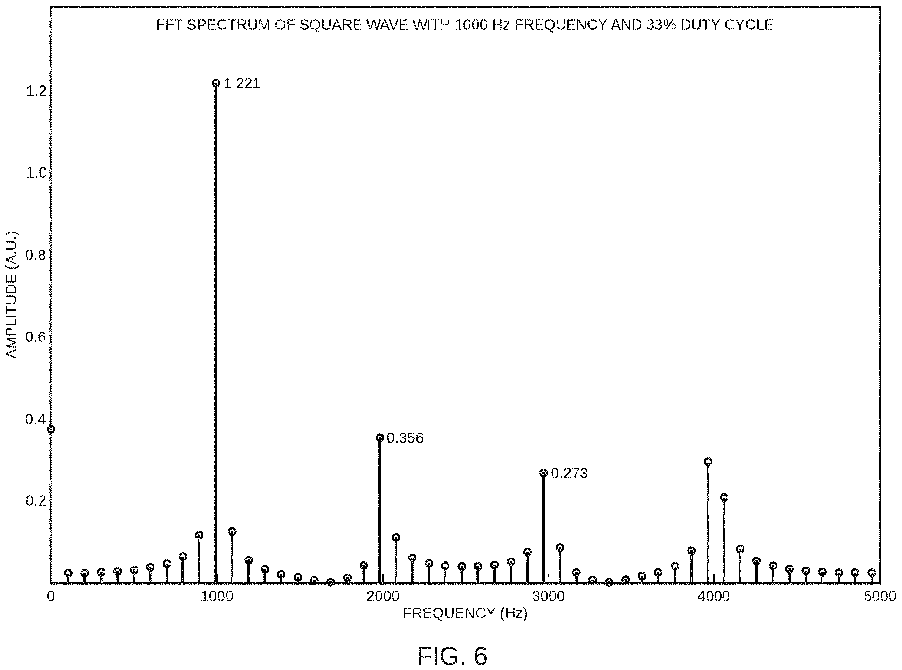

As shown in FIG. 6, using the 33.33% RF input signal duty-cycle does not change the first-order harmonic power substantially and reduces the H3 component. The H2 component is in-phase for both differential outputs of the RF power amplifier and is suppressed by the transformer. Releasing the input signal early improves power amplifier efficiency as well. There is less power dissipated by the power amplifier 14 when the first transistor M1 and the second transistor M2 are conducting. As shown in FIG. 6, compared with a 50% duty cycle power amplifier, a 33.33% duty cycle inverse Class-D RF power amplifier improves the drain efficiency and H3 levels.

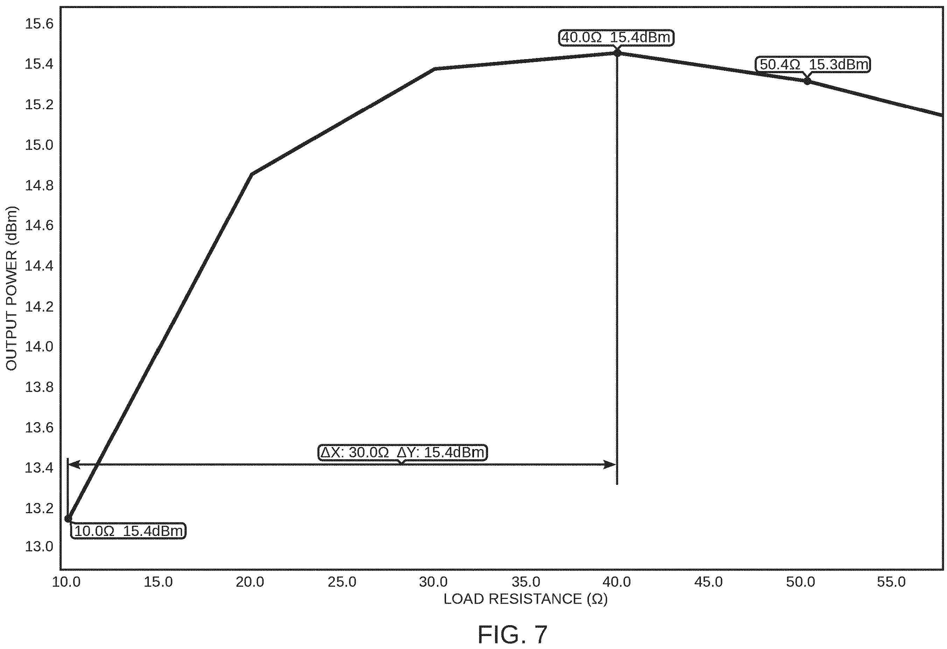

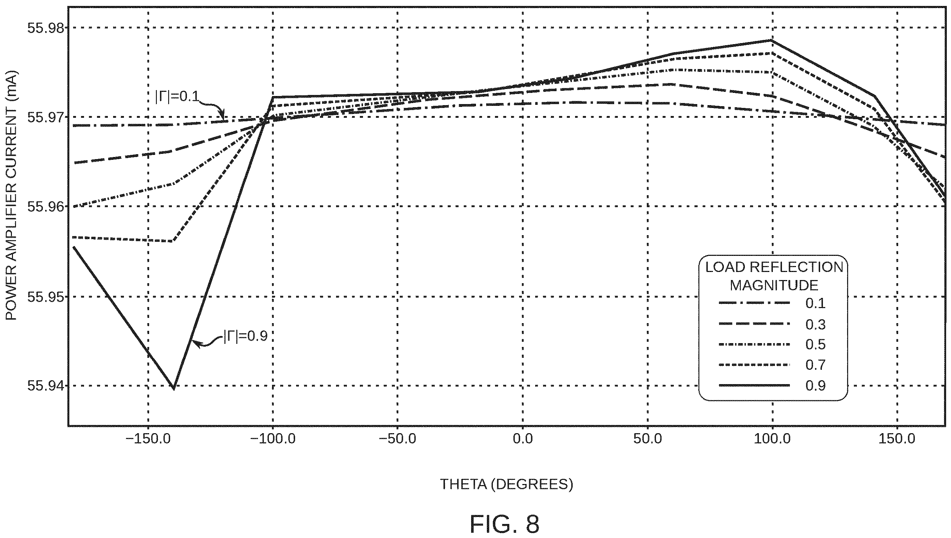

As shown in FIG. 7, output power change with different antenna impedance is very good compared with traditional constant bias power amplifier architectures. FIG. 8 is a graph of power amplifier load current versus magnitude and phase angle for various load reflection coefficients. Overall, the performance shown in FIG. 7 and FIG. 8 shows that the disclosed power amplifier circuitry provides substantial improvements in efficiency and harmonic distortion for low-power, low-cost radios. By using a self-biased architecture with I-DAC 34, the output power programming is simplified, and the spread over process voltage and temperature is improved. The RF transformer 16 may be fully integrated and configured as a balun so that the differential inverse class D RF power amplifier reduces second harmonic generation, while the 33% duty-cycled RF signal reduces third harmonic components, leading to lower current consumption and improved battery lifetime.

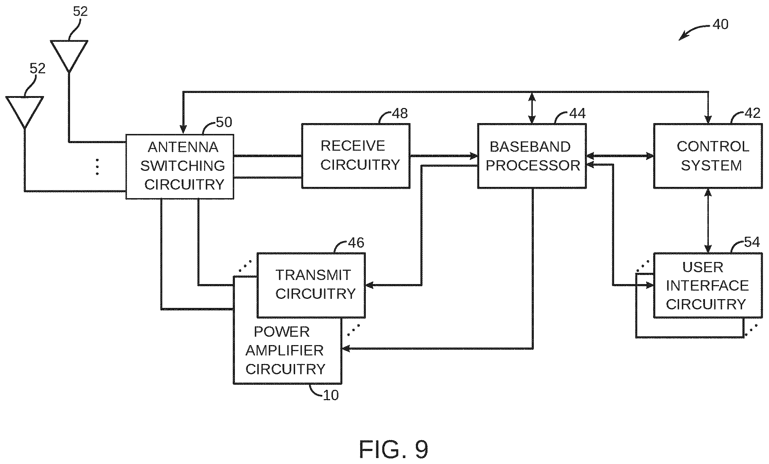

FIG. 9 is a diagram showing how the disclosed power amplifier circuitry 10 may be employed in communication devices such as wireless communication devices. With reference to FIG. 9, the concepts described above may be implemented in various types of wireless communication devices or user elements 40, such as mobile terminals, smart watches, tablets, computers, navigation devices, access points, and the like that support wireless communications, such as cellular, wireless local area network (WLAN), Bluetooth, near-field communications, and ultra-wideband ranging. The user elements 40 will generally include a control system 42, a baseband processor 44, transmit circuitry 46, receive circuitry 48, antenna switching circuitry 50, multiple antennas 52, and user interface circuitry 54. Amplifiers in the transmit circuitry 46 are powered from the power amplifier circuitry 10. The baseband processor 44 is configured to set an appropriate output voltage for the transmit circuitry 46. The receive circuitry 48 receives radio frequency signals including ultra-wide bandwidth signals via the antennas 52 and through the antenna switching circuitry 50 from one or more base stations and/or other wireless communication devices configured like the wireless communication device 40. A low-noise amplifier and a filter cooperate to amplify and remove broadband interference from the received signal for processing. Downconversion and digitization circuitry (not shown) will then downconvert the filtered, received signal to an intermediate or baseband frequency signal, which is then digitized into one or more digital streams.

The baseband processor 44 processes the digitized received signal to extract the information or data bits conveyed in the received signal. This processing typically comprises demodulation, decoding, and error correction operations. The baseband processor 44 is generally implemented in one or more digital signal processors and application-specific integrated circuits.

For transmission, the baseband processor 44 receives digitized data, which may represent voice, data, or control information, from the control system 42, which it encodes for transmission. The encoded data is output to the transmit circuitry 46, where it is used by a modulator to modulate a carrier signal that is at a desired transmit frequency or frequencies, such as ultra-wideband frequencies, which span 3.1 GHz to 10.5 GHz. The bandwidth of ultra-wideband is greater than 500 MHz.

A power amplifier will amplify the modulated carrier signal to a level appropriate for transmission and deliver the modulated carrier signal through the antenna switching circuitry 50 to the antennas 52. The antennas 52 and the replicated transmit circuitry 46 and receive circuitry 48 may provide spatial diversity. Modulation and processing details will be understood by those skilled in the art.

Therefore, from one perspective, there have been described approaches for power amplifier circuitry having an inverse Class-D amplifier functioning as a power amplifier and self-biasing circuitry generating gate bias voltages for switching type power transistors within the power amplifier. The self-biasing circuitry includes a low-dropout regulator that generates and applies a gate bias voltage in response to a feedback current scaled according to the power amplifier's operating current. A current-based digital-to-analog converter is configured to generate the reference current based on a received digital value. Additionally, a digital processor is configured to generate the digital value in response to the gate bias voltage. The power amplifier circuitry enhances performance and efficiency while ensuring precise control over power transistors' operation, offering advantages for various applications requiring radio frequency signal amplification.

Further examples of feature combinations taught by the present disclosure are set out in the following numbered clauses.

Clause 1. Power amplifier circuitry comprising: a power amplifier configured as an inverse Class-D amplifier; and self-biasing circuitry comprising: a low-dropout regulator configured to generate and apply a gate bias voltage to switching type power transistors that comprise the power amplifier in response to a feedback current that is scaled to a power amplifier current flowing in the power amplifier; a current-based digital-to-analog converter configured to generate the feedback current based on a received digital value; and a digital processor configured to generate the digital value in response to the gate bias voltage.

Clause 2. The power amplifier circuitry of clause 1 wherein the switching type transistors are a first transistor and a second transistor that are laterally diffused metal-oxide semiconductor type switching transistors.

Clause 3. The power amplifier circuitry of clause 2 further comprising a third transistor and a fourth transistor coupled in cascode with the first transistor and the second transistor, respectively, to isolate inputs of the power amplifier from high output voltage swings and improve switching efficiency.

Clause 4. The power amplifier circuitry of clause 2 or 3 further comprising an RF transformer having a tapped input winding coupled to drains of the first and second transistors, and an output winding coupled between an antenna and ground.

Clause 5. The power amplifier circuitry of any preceding clause wherein the feedback current is generated based on a power amplifier current flowing in the power amplifier and scaled by a first p-type metal-oxide semiconductor transistor that mirrors the power amplifier current.

Clause 6. The power amplifier circuitry of any preceding clause wherein a self-biasing feedback loop is closed between the power amplifier and the self-biasing circuitry to provide power amplifier current stabilization for a desired output power level.

Clause 7. The power amplifier circuitry of clause 6 wherein the self-biasing feedback loop controls the output power level to an antenna load by comparing the current supplied by the power amplifier to the antenna load with a reference current to adjust the output power level to maintain a constant level of the output power level despite changes in load impedance.

Clause 8. The power amplifier circuitry of any preceding clause wherein the power amplifier is configured to amplify a 33% duty-cycled RF signal to reduce a third-order harmonic component to improve power amplifier drain efficiency.

Clause 9. The power amplifier circuitry of any preceding clause wherein the current-based digital-to-analog converter comprises 4-bit binary scaled current sources.

Clause 10. The power amplifier circuitry of any preceding clause wherein the current-based digital-to-analog converter is configured to adjust the feedback current generated by the current-based digital-to-analog converter to between 2µA and 512µA.

Clause 11. A method of operating a power amplifier circuitry, the method comprising: amplifying a radio frequency (RF) signal using an inverse Class-D configuration with a power amplifier; generating and applying a gate bias voltage to switching type power transistors that make up the power amplifier using a low-dropout regulator in response to a feedback current that is scaled to a power amplifier current flowing in the power amplifier; generating the reference current based on a received digital value using a current-based digital-to-analog converter; and generating the digital value in response to the gate bias voltage using a digital processor.

Clause 12. The method of clause 11 further comprising making the switching type transistors laterally diffused metal-oxide semiconductor type switching transistors.

Clause 13. The method of clause 12 further comprising coupling a third transistor and a fourth transistor in cascode with the first transistor and the second transistor, respectively, to isolate inputs of the power amplifier from high output voltage swings and improve switching efficiency.

Clause 14. The method of clause 12 or 13 further comprising using an RF transformer having a tapped input winding coupled to drains of the first transistor and the second transistor, and an output winding coupled between an antenna and ground.

Clause 15. The method of any of clauses 11 to 14 wherein generating the feedback current comprises mirroring the power amplifier current using a first p-type metal-oxide semiconductor (PMOS) transistor.

Clause 16. The method of any of clauses 11 to 15 further comprising closing a self-biasing feedback loop between the power amplifier and the self-biasing circuitry to provide power amplifier current stabilization for a desired output power level.

Clause 17. The method of clause 16 wherein controlling the output power level comprises comparing the current supplied by the power amplifier to an antenna load with a reference current to adjust the output power level to maintain a constant level of the output power level despite changes in load impedance.

Clause 18. The method of any of clauses 11 to 17 further comprising amplifying a 33% duty-cycled RF signal to reduce a third-order harmonic component and improve power amplifier drain efficiency.

Clause 19. The method of any of clauses 11 to 18 wherein the current-based digital-to-analog converter comprises 4-bit binary scaled current sources.

Clause 20. The method of any of clauses 11 to 19 wherein adjusting the feedback current comprises adjusting the feedback current to between 2µA and 512µA using the current-based digital-to-analog converter.

Clause 21. A wireless communication device comprising: receive circuitry configured to receive radio frequency (RF) signals; a baseband processor configured to process a digitized version of the RF signals received by the receive circuitry and to extract the information or data bits conveyed in the received RF signals; transmit circuitry configured to receive encoded data from the baseband processor and to modulate a carrier signal with the encoded data; and power amplifier circuitry coupled to the transmit circuitry, the power amplifier circuitry comprising: a power amplifier configured as an inverse Class-D amplifier; and self-biasing circuitry comprising: a low-dropout regulator configured to generate and apply a gate bias voltage to switching type power transistors that comprise the power amplifier in response to a feedback current that is scaled to a power amplifier current flowing in the power amplifier; a current-based digital-to-analog converter configured to generate the reference current based on a received digital value; and a digital processor configured to generate the digital value in response to the gate bias voltage.

Clause 22. The wireless communication device of clause 21 wherein the switching type transistors are a first transistor and a second transistor that are laterally diffused metal-oxide semiconductor type switching transistors.

Clause 23. The wireless communication device of clause 22 further comprising a third transistor and a fourth transistor coupled in cascode with the first transistor and the second transistor, respectively, to isolate inputs of the power amplifier from high output voltage swings and improve switching efficiency.

Clause 24. The wireless communication device of clause 22 or 23 further comprising an RF transformer having a tapped input winding coupled to drains of the first transistor and the second transistor, and an output winding coupled between an antenna and ground.

Clause 25. The wireless communication device of any of clauses s21 to 24 wherein the feedback current is generated based on a power amplifier current flowing in the power amplifier and scaled by a first p-type metal-oxide semiconductor transistor that mirrors the power amplifier current.

Clause 26. The wireless communication device of any of clauses 21 to 25 wherein a self-biasing feedback loop is closed between the power amplifier and the self-biasing circuitry to provide power amplifier current stabilization for a desired output power level.

Clause 27. The wireless communication device of clause 26 wherein the self-biasing feedback loop controls the output power level to an antenna load by comparing the current supplied by the power amplifier to the antenna load with a reference current to adjust the output power level to maintain a constant level of the output power level despite changes in load impedance.

Clause 28. The wireless communication device of any of clauses 21 to 27 wherein the power amplifier is configured to amplify a 33% duty-cycled RF signal to reduce a third-order harmonic component to improve power amplifier drain efficiency.

Clause 29. The wireless communication device of any of clauses 21 to 28 wherein the current-based digital-to-analog converter comprises 4-bit binary scaled current sources.

Clause 30. The wireless communication device of any of clauses 21 to 29 wherein the current-based digital-to-analog converter is configured to adjust the feedback current generated by the current-based digital-to-analog converter to between 2µA and 512µA.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrated embodiments of the present disclosure. All such improvements and modifications are considered within the scope of the concepts disclosed herein and the claims that follow.

## Claims

1. Power amplifier circuitry comprising:
• a power amplifier configured as an inverse Class-D amplifier; and
• self-biasing circuitry comprising:
• a low-dropout regulator configured to generate and apply a gate bias voltage to switching type power transistors that comprise the power amplifier in response to a feedback current that is scaled to a power amplifier current flowing in the power amplifier;
• a current-based digital-to-analog converter configured to generate the feedback current based on a received digital value; and
• a digital processor configured to generate the digital value in response to the gate bias voltage.

2. The power amplifier circuitry of claim 1 wherein the switching type transistors are a first transistor and a second transistor that are laterally diffused metal-oxide semiconductor type switching transistors.

3. The power amplifier circuitry of claim 2 further comprising a third transistor and a fourth transistor coupled in cascode with the first transistor and the second transistor, respectively, to isolate inputs of the power amplifier from high output voltage swings and improve switching efficiency.

4. The power amplifier circuitry of claim 2 or 3 further comprising an RF transformer having a tapped input winding coupled to drains of the first and second transistors, and an output winding coupled between an antenna and ground.

5. The power amplifier circuitry of any preceding claim wherein the feedback current is generated based on a power amplifier current flowing in the power amplifier and scaled by a first p-type metal-oxide semiconductor transistor that mirrors the power amplifier current.

6. The power amplifier circuitry of any preceding claim wherein a self-biasing feedback loop is closed between the power amplifier and the self-biasing circuitry to provide power amplifier current stabilization for a desired output power level.

7. The power amplifier circuitry of claim 6 wherein the self-biasing feedback loop controls the output power level to an antenna load by comparing the current supplied by the power amplifier to the antenna load with a reference current to adjust the output power level to maintain a constant level of the output power level despite changes in load impedance.

8. The power amplifier circuitry of any preceding claim wherein the power amplifier is configured to amplify a 33% duty-cycled RF signal to reduce a third-order harmonic component to improve power amplifier drain efficiency.

9. The power amplifier circuitry of any preceding claim wherein the current-based digital-to-analog converter comprises 4-bit binary scaled current sources.

10. The power amplifier circuitry of any preceding claim wherein the current-based digital-to-analog converter is configured to adjust the feedback current generated by the current-based digital-to-analog converter to between 2µA and 512µA.

11. A wireless communication device comprising:
• receive circuitry configured to receive radio frequency (RF) signals;
• a baseband processor configured to process a digitized version of the RF signals received by the receive circuitry and to extract the information or data bits conveyed in the received RF signals;
• transmit circuitry configured to receive encoded data from the baseband processor and to modulate a carrier signal with the encoded data; and
• the power amplifier circuitry of any of preceding claim coupled to the transmit circuitry.

12. A method of operating a power amplifier circuitry, the method comprising:
• amplifying a radio frequency (RF) signal using an inverse Class-D configuration with a power amplifier;
• generating and applying a gate bias voltage to switching type power transistors that make up the power amplifier using a low-dropout regulator in response to a feedback current that is scaled to a power amplifier current flowing in the power amplifier;
• generating the reference current based on a received digital value using a current-based digital-to-analog converter; and
• generating the digital value in response to the gate bias voltage using a digital processor.

13. The method of claim 12 further comprising configuring the power amplifier circuit to have the properties defined in any of claims 2 to 4 or 9.

14. The method of claim 12 or 13 wherein generating the feedback current comprises mirroring the power amplifier current using a first p-type metal-oxide semiconductor (PMOS) transistor.

15. The method of any of claims 12 to 14 further comprising closing a self-biasing feedback loop between the power amplifier and the self-biasing circuitry to provide power amplifier current stabilization for a desired output power level for example wherein controlling the output power level comprises comparing the current supplied by the power amplifier to an antenna load with a reference current to adjust the output power level to maintain a constant level of the output power level despite changes in load impedance.

16. The method of any of claims 12 to 15 further comprising amplifying a 33% duty-cycled RF signal to reduce a third-order harmonic component and improve power amplifier drain efficiency.

17. The method of any of claims 12 to 16 wherein adjusting the feedback current comprises adjusting the feedback current to between 2µA and 512µA using the current-based digital-to-analog converter.
